# EUROPEAN PATENT APPLICATION

(11) **EP 2 257 126 A1**
(43) Date of publication of application: **01.12.2010**
(21) Application number: 09711117.3
(22) Date of filing: 12.02.2009
(51) Int. Cl.: H05B 33/26, H01L 51/50, H05B 33/10

(54) **METHOD FOR TREATING SURFACE OF ELECTRODE, ELECTRODE, AND PROCESS FOR PRODUCING ORGANIC ELECTROLUMINESCENT ELEMENT**

(30) Priority: 15.02.2008 JP 2008034673
(71) Applicant: Showa Denko K.K., Tokyo 105-8518 (JP)
(72) Inventor: NATORI, Nobuhiro, Chiba-shi Chiba 267-0056 (JP); KONDO, Kunio, Chiba-shi Chiba 267-0056 (JP); SAKO, Kanjiro, Chiba-shi Chiba 267-0056 (JP)
(74) Representative: Strehl Schübel-Hopf & Partner
(86) International application number: PCT/JP2009/052320
(87) International publication number: WO 2009/101983

(57) **Abstract**

[Problems] To provide processes that can increase the work function of electrodes by simple procedures, and organic EL devices that have an anode of high work function and a quality emitting surface showing excellent luminous properties (luminous efficiency, life) without uneven brightness or defects, and are free of leakage current.

[Means for solving problems] A process for treating an electrode surface of the invention includes a contact step of bringing an electrode formed of a metal oxide or a metal into contact with an alkaline solution of a compound having an Si-O bond. An organic EL device according to the invention includes a metal oxide or metal anode that has been surface-treated by the process, and an emitting layer and a cathode laminated on the anode in this order.

## Description

### FIELD OF THE INVENTION

The present invention relates to processes for treating an electrode surface, electrodes, and organic electroluminescence devices and production processes therefor.

### BACKGROUND OF THE INVENTION

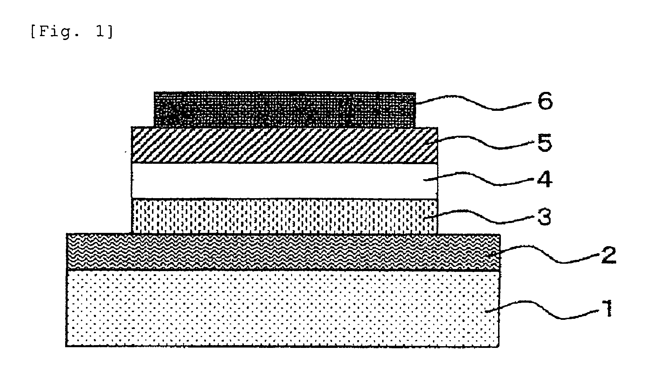

Organic electroluminescence (hereinafter, also organic EL) devices have a substrate 1, an anode 2, a hole transport layer 3, an emitting layer 4, an electron transport layer 5 and a cathode 6 that are laminated in this order, for example as illustrated in Fig. 1. When a positive voltage is applied to the anode 2 and a negative voltage to the cathode 6, electrons injected to the emitting layer 4 through the electron transport layer 5 recombine with holes injected to the emitting layer 4 through the hole transport layer 3, and thereby the emitting layer 4 emits light.

For the application of organic EL devices to full color displays or illumination, the requirements are that the drive voltage of the devices is reduced and the luminous efficiency is enhanced. To reduce the drive voltage of the devices, positive charges (holes) supplied from the anode 2 and electrons from the cathode 6 should be injected to the emitting layer 4 more efficiently. An approach for increasing the hole injection efficiency of the anode 2 is to increase the work function of the anode 2 and reduce the energy barrier to the hole transport layer 3.

ITO (indium tin oxide), which is generally used as anodes, is considered to have a work function of about -6.0 eV in principle. However, the general practice of washing with organic solvents decreases the work function to as low as about -4.8 to -4.7 eV. This is probably because residual carbon components originating from the organic solvents remain on the surface of the anodes or oxygen molecules on the ITO surface are lost. Accordingly, the washing may be followed by treatments such as UV ozone washing and oxygen plasma treatment.

To increase the work function of anode metals, JP-A-H04-14795 (Patent Document 1) and JP-A-H09-120890 (Patent Document 2) disclose processes in which the anode surface is acid treated. According to Patent Document 1, the surface of an anode is acid treated, washed with an organic solvent and dried. This treatment increases the anode's work function by about 0.1 to 0.3 eV compared to that before the acid treatment, and the increased work function of the anode leads to the lowering of drive voltage of devices. According to Patent Document 2, the surface of an anode is polished, then acid treated, washed with an organic solvent and dried. By the treatment, the anode surface is planarized and pores are created on the uppermost surface, thereby achieving a lowered drive voltage and an increased life of devices.

However, the increase in work function according to Patent Documents 1 and 2 is insufficient because the anodes are washed with organic solvents after the acid treatment and residual carbon components originating from the organic solvents remain on the surface of the anodes. Further, organic electroluminescence devices manufactured according to the patent documents decrease brightness during continuous drive, and the resistance in the devices increases during continuous use.

JP-A-2001-319777 (Patent Document 3) discloses that an anode is acid treated and an organic emitting layer and the like are formed on the anode without washing of the anode after the acid treatment, and thereby the work function of the anode is increased and the drive voltage of the device is lowered. However, the devices have insufficient life properties and require improvements.

JP-A-2004-63210 (Patent Document 4) discloses a process in which the surface of an anode is washed by UV washing with low pressure mercury lamp irradiation, UV washing with excimer lamp irradiation, normal pressure plasma washing or vacuum plasma washing, and is thereafter treated with an acid, halogen or the like to increase the work function of the anode. This process, however, has problems such as complicated operations.

JP-A-2007-242481 (Patent Document 5) discloses a process for treating an electrode surface in which a metal oxide electrode is brought into contact with a nonionic surfactant and/or a carboxylic acid surfactant. According to the process, the work function of electrodes of metal oxides such as indium tin oxide (hereinafter, also ITO) is increased easily. The increased work function of an anode by the process leads to improved hole injection efficiency and a lower drive voltage of devices. The document further describes that the obtainable organic EL devices have improvements in life properties and color stability during continuous operation, and the increase in resistance is minimized.

Patent Document 6 (US Patent No. 6127004) describes that a fluorocarbon compound layer is formed on an anode by plasma surface treatment in the production of organic EL devices, and the obtainable organic EL devices achieve higher luminous efficiency.

Patent Document 7 (JP-A-H09-63771) describes that in the production of organic EL devices, a metal oxide layer is formed on an ITO anode and thereby higher luminous efficiency of organic EL devices is achieved. The metal oxides disclosed include RuOₓ, MoOₓ, VOₓ and the like. The metal oxide layers are formed by methods such as electron beam deposition, direct current sputtering, RF magnetron sputtering and ICB deposition.

However, the inventions according to Patent Documents 6 and 7 involve a vacuum atmosphere in the production of the layers on the anodes, and handling is complicated.
Patent Document 8 (JP-A-H09-7770) describes that the use of smooth surface anodes prevents short circuits due to pinholes and provides improved luminous brightness and luminous efficiency, leading to thin film organic EL devices having superior durability and reliability.
Patent Document 1: JP-A -H04-14795
Patent Document 2: JP-A-H09-120890
Patent Document 3: JP-A-2001-319777
Patent Document 4: JP-A-2004-63210
Patent Document 5: JP-A-2007-242481
Patent Document 6: US Patent No. 6127004
Patent Document 7: JP-A-H09-63771
Patent Document 8: JP-A-H09-7770

### SUMMARY OF THE INVENTION

The present invention has been made in view of the problems in the art as described above. It is therefore an object of the invention to provide processes for increasing the work function of electrodes by simple operations.
It is another object of the invention to provide processes for easily manufacturing organic EL devices that have an anode with a high work function.

In detail, an object of the invention is to provide organic EL devices having improved luminous properties (luminous efficiency, life), and processes for producing such EL devices.
In particular, it is an object of the invention that an emitting layer is formed by an application method with high uniformity and smoothness and thereby organic EL devices are manufactured which have a quality emitting surface without uneven brightness or defects and have no leakage current. It is another object of the invention to provide processes for producing such organic EL devices.

The present invention is concerned with the following [1] to [19].
[1] A process for treating an electrode surface, comprising a contact step of bringing an electrode comprising a metal oxide or a metal into contact with an alkaline solution of a compound having an Si-O bond.

[2] The process for treating an electrode surface as described in [I], wherein the compound having an Si-O bond is a silicate.

[3] The process for treating an electrode surface as described in [2], wherein the silicate is at least one selected from the group consisting of sodium silicate, potassium silicate, rubidium silicate and lithium silicate.

[4] The process for treating an electrode surface as described in any one of [1] to [3], wherein the alkaline solution contains the compound having an Si-O bond in a concentration of 0.001 to 15% by mass in terms of Si atoms.

[5] The process for treating an electrode surface as described in any one of [1] to [4], wherein the alkaline solution contains an alkali metal ion and the molar concentration of the alkali metal ion in the alkaline solution is 0.1 to 10 times the molar concentration in terms of Si atoms of the compound having an Si-O bond.

[6] The process for treating an electrode surface as described in any one of [1] to [5], wherein the contact step is performed by soaking the electrode in the alkaline solution.

[7] The process for treating an electrode surface as described in any one of [1] to [5], wherein the contact step is performed by spraying the alkaline solution to the electrode.

[8] The process for treating an electrode surface as described in any one of [1] to [5], wherein the contact step is performed by applying the alkaline solution to the surface of the electrode.

[9] The process for treating an electrode surface as described in [8], wherein the application is performed by forming a puddle of the alkaline solution on the surface of the electrode and rotating the electrode in an in-plane direction of the electrode surface to spread the puddle of the solution over the entire surface of the electrode.

[10] The process for treating an electrode surface as described in [9], wherein the application is performed by a spin coating method or a casting method.

[11] The process for treating an electrode surface as described in [8], wherein the application is performed by a microgravure coating method, a gravure coating method, a bar coating method, a roll coating method, a wire bar coating method, a dip coating method, a spray coating method, a screen printing method, a flexographic printing method, an off-set printing method or an inkjet printing method.

[12] The process for treating an electrode surface as described in any one of [1] to [11], wherein the process further comprises a washing step of washing the electrode with water after the contact step.

[13] The process for treating an electrode surface as described in [12], wherein the washing step is performed by at least one method selected from the group consisting of a brush washing method, a two-fluid washing method, an ultrasonic washing method, a high-pressure jet washing method and a spin washing method.

[14] The process for treating an electrode surface as described in any one of [1] to [13], wherein the process further comprises a heating step of heating the electrode to 60 to 250°C, the heating step being performed at a stage after the contact step (when the process comprises the washing step, the heating step being performed at a stage after the washing step).

[15] The process for treating an electrode surface as described in any one of [1] to [14], wherein the process further comprises a UV irradiation step of irradiating the electrode with UV rays, the UV irradiation step being performed at a stage after the contact step (when the process comprises the washing step, the UV irradiation step being performed at a stage after the washing step).

[16] An electrode comprising a metal oxide or a metal, which has been surface-treated by the process described in any one of [1] to [15].

[17] An electrode comprising indium tin oxide, which has been surface-treated by the process described in any one of [1] to [15] and has a work function of -5.2 to -6.0 eV as measured by ultraviolet photoelectron spectroscopy in the air.

[18] A process for manufacturing organic electroluminescence devices which comprise an anode, an emitting layer and a cathode laminated in this order, wherein the process comprising forming the emitting layer and the cathode on the anode that comprises a metal oxide or a metal and has been surface-treated by the process described in any one of [1] to [15].

[19] An organic electroluminescence device comprising an anode, an emitting layer and a cathode laminated in this order, wherein the anode comprises a metal oxide or a metal and has been surface-treated by the process described in any one of [1] to [15].

### ADVANTAGEOUS EFFECTS OF THE INVENTION

According to the processes for treating an electrode surface of the invention, the work function of electrodes formed of metal oxides such as indium tin oxide (hereinafter, also ITO) or metals can be increased easily.
According to the invention, organic EL devices having a metal oxide or metal electrode (anode) of high work function can be manufactured easily.

According to the invention, luminous properties (luminous efficiency, life) of organic EL devices are improved.
According to the invention, the surface-treated anodes achieve improved wettability with a solution for forming an emitting layer and thereby allow for the production of emitting layers having high uniformity and smoothness in particular when the emitting layers are formed by an application method. As a result, organic EL devices are manufactured which have a quality emitting surface without uneven brightness or defects and have no leakage current. The processes of the invention can produce such organic EL devices.

### BRIEF DESCRIPTION OF THE DRAWING

Fig. 1 is a cross sectional view showing an embodiment of organic EL devices manufactured by the process of the invention.

1: transparent substrate
2: anode
3: hole transport layer
4: emitting layer
5: electron transport layer
6: cathode

### PREFERRED EMBODIMENTS FOR CARRYING OUT THE INVENTION

There will be described in detail hereinbelow the processes for treating an electrode surface, electrodes, organic electroluminescence devices, and processes for manufacturing an organic electroluminescence device according to the present invention.

### [Processes for treating an electrode surface, and electrodes]

### (Contact step)

Processes for treating an electrode surface of the invention include a contact step (also a "contact treatment step") of bringing an electrode comprising a metal oxide or a metal into contact with an alkaline solution of a compound having an Si-O bond.

When the electrodes are anodes for organic EL devices, the contact step generally takes place between a substrate on which the metal oxide or metal electrode is mounted (hereinafter, also an "electrode-mounted substrate") and the alkaline solution.

Examples of the materials for the electrodes include metal oxides such as indium tin oxide (ITO) and indium zinc oxide (IZO); metals such as single metals (for example, copper, silver, gold, platinum, tungsten, titanium, tantalum and niobium); alloys of these metals; and stainless steel.

The compounds having an Si-O bond are preferably silicates. In a more preferred embodiment, at least one silicate (alkali metal silicate) is selected from the group consisting of sodium silicate, potassium silicate, rubidium silicate and lithium silicate. The alkaline solutions of these compounds are stable at and around normal temperature.

The silicates may be orthosilicates, metasilicates or polysilicates.
Preferred silicates are composed of chain silicate ions and alkali metal ions. Although variable depending on the molecular weight of the silicate ions, the alkaline solutions of such silicates do not gel and will have a viscosity (about 0.1 to 100 cPs) such that good handling properties are obtained in the contact step.

Hydrophilic solvents are preferable for the solutions. Compounds having a hydroxyl group, compounds having an ether bond, and water are more preferable. Alcohols, cyclic ethers and water are still more preferable, and water is particularly preferable. The solvents may be used singly, or two or more kinds may be used in combination. When the compound having an Si-O bond is a silicate, the silicate ions and the cations such as alkali metal ions are solvated by the above solvents. The solvation keeps the silicate ions away from one another, giving a homogeneous solution.

If the contact step is conducted while the solution contains insoluble matters or gels, such insoluble matters or gels attach to the surface of the electrode or the electrode-mounted substrate, inhibiting uniform surface treatment of the electrode. The use of such electrodes as anodes in organic EL devices may result in uneven brightness on the emitting surface of the organic EL devices. In view of these disadvantages, the solution is preferably prepared uniform with stirring, and insoluble matters or gels present in the solution are preferably removed by filtration. Filters for the filtration preferably have an average pore size of not more than 0.5 µm, and more preferably not more than 0.2 µm. The lower limit of the average pore size may be, for example, 0.05 µm.

The solution is preferably a solution of a silicate, more preferably an aqueous solution of the alkali metal silicate, and particularly preferably a diluted aqueous solution of liquid glass. These solutions, particularly aqueous solutions, keep the silicate ions away from one another as described above. According to Pearson' s hard soft acid base principle, the alkali metal ions are strong acids and water is hard base. Therefore, when the solution contains alkali metal ions and water, the alkali metal ions are strongly solvated (hydrated) and consequently the silicate ions can exist stably in the solution.

The solutions are alkaline with a pH generally in the range of 9 to 14, and preferably 10 to 13 at room temperature (25°C). If the pH is excessively high, the electrodes may be corroded (dissolved). With an excessively low pH, the solution may be gelled and, because the concentration of ions derived from the Si-O bond-having compounds such as silicate ions is low, the level of contact treatment may vary during the contact treatment step and the contact treatment step may result in unstable results.

When the alkaline solution is allowed to stand in the air at normal temperature and normal pressure, carbon dioxide in the air is dissolved in the alkaline solution. As a result, the pH of the alkaline solution gradually decreases, although the decrease takes place very slowly. When the alkaline solution is stored for a long term, the solution is preferably placed in a highly airtight container to eliminate any contact with air.

In the alkaline solutions, the concentration of the compounds having an Si-O bond (or the concentration of silicate ions derived from the compounds) is usually not more than 20% by mass in terms of Si atoms, preferably in the range of 0.001 to 15% by mass, more preferably 0.01 to 3% by mass, and still more preferably 0.05 to 1% by mass. When the concentration is high, the contact step is completed in a short time. When the concentration is low, the contact step is reproduced and controlled easily and the contact step takes place stably. On the other hand, if the concentration is in excess of the above range, it is sometimes difficult to reproduce or control the contact step and to remove the solution from the electrode surface after the completion of the contact step. If the concentration is below the above range, the contact step may take a long time or the contact treatment step may be unstable because the change in concentration of the solution during the contact treatment step has greater influences on the level of contact treatment.

In the alkaline solutions, the concentration of the alkali metal ions is preferably 0.1 to 10 times, and more preferably 0.25 to 2 times the concentration of the compounds having an Si-O bond (or the concentration of ions released therefrom such as silicate ions) in terms of Si atoms. The alkali metal ions in this concentration function as counterions to the silicate ions, i.e., allow the silicate ions to exist stably in the solution.

The solutions preferably have a viscosity (about 0.1 to 100 cPs) such that the electrodes can be soaked in the solutions or the solutions can be sprayed to the electrodes.
The alkaline solutions may further contain surfactants. The surfactants lower the surface tension of the alkaline solutions, and the alkaline solutions can wet the electrodes more easily, thereby achieving more uniform contact treatment.

In detail, a nonionic surfactant and/or a carboxylic acid surfactant may be used as the surfactant.

### Examples of the nonionic surfactants include polyoxyethylene alkyl phenyl ethers, polyoxyethylene alkyl ethers and acyl glycerols. Examples of the carboxylic acid surfactants include aliphatic monocarboxylates (fatty acid soaps) and alkanoyl sarcosines.

The surfactants may be used singly, or two or more kinds may be used in combination.
The contact step is preferably performed by soaking the electrode or the electrode-mounted substrate in the solution (hereinafter, also the "soaking method"), by spraying the solution to the electrode or the electrode-mounted substrate (hereinafter, also the "spraying method"), or by applying the solution to the electrode or the electrode-mounted substrate (hereinafter, also the "application method"). The contact step by these methods can treat the entire surface of the electrode or the electrode-mounted substrate at one time and uniformly. Of the above methods, the application method is preferable because it can treat particularly uniformly the surface of the electrode or the electrode-mounted substrate. Uniform treatment of the surface of the electrodes or the electrode-mounted substrates may be confirmed by confirming that the organic EL devices fabricated using the treated electrodes have a small unevenness in brightness.

When the contact step is performed by the soaking method, the reproducibility of the surface treatment of electrodes may be enhanced by controlling the concentration and temperature of the alkaline solutions, the soaking time, and the operation of a stirring apparatus.

In the soaking method, the electrodes or the electrode-mounted substrates may be generally soaked in the solution for not less than 5 minutes, preferably not less than 30 minutes, and more preferably not less than 2 hours. The upper limit of the soaking time is not particularly limited, and the soaking time may be as long as 48 hours.

In order to treat the electrode surface even more uniformly, the contact step by the soaking method preferably involves swaying the electrodes, stirring the solution or ultrasonicating the solution during the soaking.

When the contact step is performed by the spraying method, an embodiment may be adopted wherein a member from which the solution is sprayed is fixed and the electrodes or the electrode-mounted substrates are moved relative to the member while the solution is sprayed thereto. According to this embodiment, the electrodes or the electrode-mounted substrates may be treated continuously, and even electrode-mounted substrates having a large size may be treated easily.

In the spraying method, the solution may be generally sprayed to the electrodes or the electrode-mounted substrates for not less than 5 minutes, and preferably from 10 minutes to 1 hour.
In order to treat the electrode surface even more uniformly, the contact step by the spraying method is preferably carried out by spraying the solution over the entire electrode surface, by spraying the solution using an ultrasonic nozzle, by spraying the solution using a two-fluid nozzle, or by spraying the solution using a high-pressure nozzle.

When the contact step is performed by the application method, an embodiment may be adopted wherein a puddle of the alkaline solution is formed on the surface of the electrode and the electrode is rotated in an in-plane direction of the electrode surface to spread the puddle of the solution over the entire surface of the electrode. In more detail, the electrode or the electrode-mounted substrate may be fixed to a rotary head, the solution may be placed thereon by dropping or the like to form a puddle of the solution in the vicinity of the rotational axis, and the electrode or the electrode-mounted substrate may be rotated at a high speed in an in-plane direction of the surface about the gravity center of the electrode or the electrode-mounted substrate thereby to form a layer of the solution over the entire surface of the electrode or the electrode-mounted substrate. The extra portion of the solution is removed by the rotation.

The application according to the above embodiment (hereinafter, also the rotation method) provides a layer of the solution in a uniform thickness and with uniformity over the entire surface of the electrode or the electrode-mounted substrate, and the surface of the electrodes or the electrode-mounted substrates may be treated uniformly.

As compared to the soaking method and the spraying method, the rotation method can treat the surface of the electrodes of the electrode-mounted substrates more uniformly and more quickly. This method has another advantage that controlling the rotation speed allows for fine adjustments of the level of surface treatment for the electrodes.

The rotation methods include a spin coating method and a casting method. Known spin coaters and casting apparatuses may be used.

The rotation speed depends on the size or weight of the electrodes or the electrode-mounted substrates, but is usually about 10 to 10000 rpm. The lower the rotation speed, the thicker the layer of the solution remaining on the surface of the electrodes or the electrode-mounted substrates and the higher the level of the surface treatment. As the rotation speed is higher, the thickness of the layer becomes smaller and the level of the surface treatment is lowered.

The application methods include microgravure coating methods, gravure coating methods, bar coating methods, roll coating methods, wire bar coating methods, printing methods such as a screen printing method, a flexographic printing method, an off-set printing method and an inkjet printing method, dip coating methods and spray coating methods.

These methods can form layers of the solution in a uniform thickness on the surface of the electrodes or the electrode-mounted substrates. Controlling the thickness of the solution layer allows for adjustments of the level of surface treatment. In detail, the thicker the layer of the solution, the higher the level of the surface treatment; and the smaller the thickness of the solution layer, the lower the level of the surface treatment. As compared to the soaking method and the spraying method, the application method can treat the surface of the electrodes of the electrode-mounted substrates more uniformly.

The printing methods may be carried out with conventional printing apparatuses, and the solution instead of a printing ink may form a layer in a uniform thickness on the surface of the electrodes or the electrode-mounted substrates.

The application of the solution by the printing method generally takes place within 1 minute, and preferably in 0.1 to 5 seconds.
In the dip coating method, the electrode or the electrode-mounted substrate is dipped in a tank containing the solution in a manner such that the normal direction of the surface to be treated is held perpendicular to the liquid surface of the solution; and the electrode or the electrode-mounted substrate is lifted at a constant speed in a direction perpendicular to the liquid surface of the solution, whereby a homogeneous layer of the solution is formed in a uniform thickness on the surface of the electrode or the electrode-mounted substrate, and the surface of the electrode or the electrode-mounted substrate can be treated uniformly. Controlling the lift up speed allows for fine adjustments of the level of surface treatment.

In the dip coating method, conventional dip coating apparatuses may be used. The lift up speed may be generally in the range of 0.1 mm to 100 mm per second. The lower the speed, the smaller the thickness of the layer of the solution formed on the surface of the electrode or the electrode-mounted substrate. The thickness of the layer is increased by accelerating the lift up speed.

The application of the solution by the dip coating method (from the initiation of the dipping of the substrate to the completion of the lift up) generally takes place within 5 minutes, and preferably in 30 seconds to 3 minutes.
In the spray coating method, the solution is sprayed by means of a spray gun on the surface of the electrode or the electrode-mounted substrate to form a layer of the solution in a uniform thickness.

The application of the solution by the spray coating method generally takes place within 5 minutes, and preferably in 1 second to 1 minute.
When the contact step is performed by the application methods (the rotation method, the printing method, the dip coating method, the spray coating method), the thickness of the obtainable layer of the solution is preferably in the range of 0.1 to 500 µm, and more preferably 0.5 to 250 µm.

In the contact step performed by the application methods (the rotation method, the printing method, the dip coating method, the spray coating method), the electrodes or the electrode-mounted substrates are exposed to air immediately after the completion of the application, whereby the surface treatment of the electrodes is promoted. In the case where the application method is the rotation method, the rotation of the electrodes or the electrode-mounted substrates may be continuously performed during the exposure. In the case where a washing step as will be described later is performed, the exposure time, namely the time ranging from the completion of the application to the initiation of the washing step, may be generally not less than 10 seconds, preferably not less than 30 seconds, and more preferably not less than 1 minute. The upper limit of the exposure time is not particularly limited, and for example the exposure may be carried out for one day.

In the contact step, the solution preferably has a temperature of 10 to 90 °C, and more preferably 25 to 60°C. When the temperature is in excess of this range, the contact step is completed in so short a time that it is often difficult to reproduce the electrode surface treatment or to treat the surface of a single electrode uniformly or the surface of a plurality of electrodes uniformly because the electrode surface may be corroded (dissolved) or the concentration of the solution may change greatly due to an increased amount of the solvent that is evaporated. If the temperature is below the above range, the contact step may take an excessively long time.

The contact step may be carried out for a time that is determined appropriately within the above range in view of the solution concentration or the temperature of the contact treatment.
The contact step may be performed at atmospheric pressure, and complicated operations of vacuum chambers or the like may be eliminated.

According to the surface treatment processes of the present invention, the work function of metal oxide electrodes or metal electrodes is increased. Herein, the words the work function is increased mean that the absolute value of the work function is large.
For example, ITO electrodes usually have a work function of about -4.8 eV without the contact treatment. According to the surface treatment processes of the present invention, the work function (absolute value) may be increased to -5.0 eV or above, and preferably -5.2 to -6.0 eV, although the result may be variable depending on the surface condition of the electrodes before the surface treatment.

The value of the work function is that determined by ultraviolet photoelectron spectroscopy in the air.
The surface treatment processes of the invention can increase the smoothness of the treated surface of metal oxide electrodes or metal electrodes. In the case of ITO electrodes as an example, the surface roughness (Ra) of the ITO electrodes treated by the inventive processes is preferably not more than 0.6 nm, and more preferably not more than 0.4 nm, although the result may be variable depending on the surface treatment conditions.

If electrodes with a rough surface are used as anodes in organic EL devices, the projections on the surface of the anodes create pinholes in the emitting layers, and the organic EL devices will have short circuits or leakage current. In contrast, the electrodes that are surface-treated by the processes of the invention have a smooth surface and the use of such electrodes as anodes in organic EL devices will prevent short circuits and reduce the leakage current in organic EL devices.

Electrodes according to the present invention are metal oxide electrodes or metal electrodes that are treated by the surface treating processes of the invention. The use of the electrodes as anodes in organic EL devices increases the luminous efficiency of the organic EL devices and extends the emission lifetime. Further, the electrodes of the invention make it possible that emitting layers which are uniform and have high smoothness can be formed thereon, and therefore organic EL devices can be manufactured which have a quality emitting surface without uneven brightness or defects and have no leakage current.

The mechanism of the electrode surface treatment according to the invention is not fully understood. The present inventors, however, assume that the electrodes are surface-treated in the following mechanism.
The alkaline solution contains silicate ions. The silicate ions adsorb on the electrode to cover the entire surface of the electrode. The silicate ions then undergo redox reaction with the electrode surface or react with carbonate ions or the like originating from the air, thereby forming a silicon oxide thin layer on the anode surface.

The increased work function of electrodes according to the present invention is probably attributed to the silicon oxide thin layer.
The thin layer will be also responsible for the increased smoothness on the electrode surface.

Provided that the silicon oxide thin layer is formed on the electrode surface in the above mechanism, the thin layer has high insulating properties and the high insulating properties probably contribute to improvement in emission lifetime of the organic EL devices when the electrodes are used as anodes in organic EL devices (J. Li et al., Synthetic Metals 151 (2005) 141-146).

As compared with electrodes without the surface treatment, the electrodes of the present invention have higher wettability with respect to polymer compound solutions that are used to form organic EL compound layers in organic EL devices. Accordingly, the electrodes of the invention when used as anodes in organic EL devices permit uniform application of a polymer compound solution on the anodes and thereby allow for the fabrication of uniform organic EL compound layers.

In the case of ITO electrodes as an example, the contact angle with water is about 10 to 90° before the surface treatment while that after the surface treatment is less than 10°, although the result may be variable depending on the surface treatment conditions.

### (Washing step)

If the electrodes are left standing after the contact step while the solution still remains on the electrode surface, the electrode surface treatment proceeds to a further extent or the solvent evaporates to leave the solute precipitated on the electrode surface. When such electrodes are used as anodes in organic EL devices, the organic EL devices may have electric short circuits or the emitting surface thereof may be damaged. To prevent these problems, the surface treatment processes of the invention have a preferred embodiment in which the process, in particular when the contact step is performed by the soaking method or the spraying method, further includes a washing step of washing the electrode with water after the contact step thereby to remove the solution from the electrode surface after the contact step. When the contact step is performed by the soaking method or the spraying method, the washing step is preferably initiated immediately after the contact step (for example within 1 minute, and preferably within 30 seconds).

In the case where the contact step is performed by the application methods (the rotation method, the printing method, the dip coating method, the spray coating method), the washing step may be omitted in many cases because there is only a small amount of the solution remaining on the electrodes or the electrode-mounted substrates.

The washing methods include a brush washing method (in which the electrode or the electrode-mounted substrate is washed with a rotating roll brush while pouring water over the electrode or the electrode-mounted substrate), a two-fluid washing method (in which compressed air (pressurized at 0.2 to 1.0 MPa) and water (pressurized at 0.2 to 1.0 MPa) are injected to the electrode or the electrode-mounted substrate through a nozzle simultaneously to wash the electrode or the electrode-mounted substrate), an ultrasonic washing method (in which ultrasonicated water is injected to the electrode or the electrode-mounted substrate through a nozzle containing an ultrasonic oscillator to wash the electrode or the electrode-mounted substrate), a high-pressure jet washing method (in which water pressurized at 0.2 to 10.0 MPa is injected to the electrode or the electrode-mounted substrate to wash the electrode or the electrode-mounted substrate) and a spin washing method (in which the electrode or the electrode-mounted substrate is washed by pouring water over while rotating the electrode or the electrode-mounted substrate). These washing methods ensure more reliable removal of the solution. The materials for the brushes used in the brush washing method include nylons, polyester resins and polyvinyl alcohol resins.

In the case of the brush washing method, the electrode or the electrode-mounted substrate is preferably brought into contact with water beforehand (for example, water may be injected to the electrode or the like, or the electrode or the like may be soaked in water) in order to remove the solution more reliably.

### (Heating step)

In a preferred embodiment of the invention, the process for treating an electrode surface of the invention further includes a heating step of heating the electrode to 60 to 250°C, and preferably 80 to 200°C after the washing step. In the case where the electrodes are used as anodes in organic EL devices, the heating step is carried out before an emitting layer of an organic EL device is formed. The means for heating include infrared ray irradiation, hot airing, halogen lamp irradiation and ultraviolet irradiation using UV lamps.

The heating step increases the effects of the surface treatment for the electrodes.
When the electrodes are used as anodes in organic EL devices, the heating step increases the luminous efficiency of the obtainable organic EL devices, probably in the following exemplary mechanism. If water used in the contact step remains on or hydroxyl groups (≡Si-OH) are formed on part of the electrode in the contact step, the residual water or water formed from the hydroxyl groups passes through an emitting layer (an organic EL layer) over time and deteriorates a cathode buffer layer made of Ba, Ca, an alkali metal or the like, resulting in lowered luminous efficiency. The heating step dehydrates the electrode surface and prevents the deterioration of cathode buffer layers, leading to improved luminous efficiency.

To prevent water or organic substances from adsorbing onto the surface of the electrodes or the electrode-mounted substrates subjected to the heating step, it is preferable that the electrodes or the electrode-mounted substrates are transferred to an atmosphere (for example, nitrogen, argon or dried air) containing no water or organic substances immediately after the heating treatment. It is more preferable that the heating step is performed in such an atmosphere.

### (UV irradiation step)

In a preferred embodiment, the process for treating an electrode surface of the invention further includes a UV irradiation step of irradiating the electrode with UV rays (wavelength region: 200 to 400 nm) after the washing step. In the case where the electrodes are used as anodes in organic EL devices, the heating step is carried out before an emitting layer of an organic EL device is formed. In an embodiment where the surface treating process includes the above heating step, the UV irradiation step may be performed before, after or simultaneously with the heating step.

The UV light sources include high pressure mercury lamps, medium pressure mercury lamps, low pressure mercury lamps, xenon lamps, metal halide lamps and deuterium lamps.
The UV irradiation dose on the objects (the electrodes or the electrode-mounted substrates) is preferably in the range of 0.01 to 10 J/cm².

The UV irradiation dose is preferably uniform over the entire surface of the electrodes or the electrode-mounted substrates. When UV rays cannot be applied to the entire surface at a time, the entire surface may be irradiated by moving the electrodes or the electrode-mounted substrates or by moving the UV light source.

### [Organic EL devices and production processes therefor]

Organic EL devices according to the present invention have a structure in which an emitting layer and a cathode are laminated in this order on a metal oxide electrode or a metal electrode (anode) that has been surface-treated by the aforementioned process.

The organic EL devices may be manufactured by laminating an emitting layer and a cathode in this order on a metal oxide electrode or a metal electrode (anode) that has been surface-treated by the aforementioned process.

The constitutions of the organic EL devices will be described hereinbelow.

### (1. Constitutions of devices)

Fig. 1 is a cross sectional view showing an embodiment of the constitutions of the organic EL devices of the invention. A hole transport layer, an emitting layer and an electron transport layer are sequentially provided between an anode on a transparent substrate and a cathode.

The constitutions of the organic EL devices of the invention are not limited to the embodiment shown in Fig. 1. Other exemplary constitutions include devices in which there are provided between an anode and a cathode: (1) an anode buffer layer/a hole transport layer/an emitting layer, (2) an anode buffer layer/an emitting layer/an electron transport layer, (3) an anode buffer layer/a hole transport layer/an emitting layer/an electron transport layer, (4) an anode buffer layer/a layer containing a hole transporting compound, a luminescent compound and an electron transporting compound, (5) an anode buffer layer/a layer containing a hole transporting compound and a luminescent compound, (6) an anode buffer layer/a layer containing a luminescent compound and an electron transporting compound, (7) an anode buffer layer/a layer containing a hole electron transporting compound and a luminescent compound, and (8) an anode buffer layer /an emitting layer/a hole block layer/an electron transport layer. Although a single emitting layer is illustrated in Fig. 1, two or more emitting layers may be provided. Further, a layer containing a hole transporting compound may be in direct contact with the surface of the anode without an anode buffer layer.

Unless otherwise specified, the term organic EL compounds refers to compounds that are composed of all or one or more of electron transporting compounds, hole transporting compounds and luminescent compounds, and the term organic EL compound layers refers to layers that are composed of all or one or more of such compounds.

### (2. Anodes)

The anodes in the organic EL devices of the present invention are metal oxide electrodes or metal electrodes that have been surface-treated by the aforementioned processes.

The electrodes preferably have a surface resistance of not more than 1000 Ω per square, and more preferably not more than 100 Ω per square at temperatures of -5 to 80°C, and preferably do not change greatly the electric resistance in alkaline aqueous solutions.

In the case where the light is obtained through the anodes of the organic EL devices (bottom emission), the anodes should be transparent at visible lights (the average transmittance at 380 to 680 nm should be not less than 50%). Accordingly, the anode materials may be indium tin oxide (ITO) and indium zinc oxide (IZO). In particular, ITO is preferable as the anode for the organic EL devices because it is easily available and has particularly high resistance to alkaline solutions.

In the case where the light is obtained through the cathodes of the organic EL devices (top emission), the light transmittance of the anodes is not limited. The anode materials in such cases include ITO, IZO, stainless steel, single metals such as copper, silver, gold, platinum, tungsten, titanium, tantalum and niobium, and alloys of these metals.

In the case of bottom emission, the thickness of the anodes is preferably in the range of 2 to 300 nm to ensure high light transmittance. In the case of top emission, the anode thickness is preferably in the range of 2 nm to 2 mm.

### (3. Anode buffer layers: when Baytron or the like is used)

The anode buffer layers may be prepared by wet processes such as spin coating, casting, microgravure coating, gravure coating, bar coating, roll coating, wire bar coating, dip coating, spray coating, screen printing, flexographic printing, off-set printing and inkjet printing.

The compounds used for the layer production by the wet processes are not particularly limited as long as the compounds show good adhesion to the anode surface and the organic EL compounds contained in the layer over the anode. It is more preferable to use conventional anode buffers. Examples thereof include conductive polymers such as PEDOT-PSS which is a mixture of poly(3,4)-ethylenedioxythiophene and polystyrenesulfonate and PANI which is a mixture of polyaniline and polystyrenesulfonate. Organic solvents such as toluene and isopropyl alcohol may be added to the conductive polymers. Further, the conductive polymers may contain a third component such as surfactant. The surfactants used herein may contain a group selected from alkyl groups, alkylaryl groups, fluoroalkyl groups, alkylsiloxane groups, sulfates, sulfonates, carboxylates, amides, betaine structures and quaternary ammonium groups. Fluoride-based nonionic surfactants may also be used.

### (4. Organic EL compounds)

The compounds used in the organic EL compound layers, namely the emitting layers, the hole transport layers and the electron transport layers in the organic EL devices of the present invention may be low molecular weight compounds or high molecular weight compounds.

The organic EL compounds for forming the emitting layers in the organic EL devices of the present invention may be luminescent low molecular weight compounds and luminescent high molecular weight compounds described in Yutaka Omori, Applied Physics, Vol. 70, No. 12, pp. 1419-1425 (2001). Of these compounds, luminescent high molecular weight compounds are preferred because the device production process is simplified, and phosphorescent compounds are preferred in view of high luminous efficiency. Accordingly, phosphorescent high molecular weight compounds are particularly preferable.

The luminescent high molecular weight compounds may be classified into conjugated luminescent high molecular weight compounds and nonconjugated luminescent high molecular weight compounds. In particular, nonconjugated luminescent high molecular weight compounds are preferred.
For the reasons described above, particularly preferred luminescent materials used in the present invention are phosphorescent nonconjugated high molecular weight compounds (luminescent materials that are the phosphorescent high molecular weight compounds as described above and are at the same time the nonconjugated luminescent high molecular weight compounds).

In a preferred embodiment, the emitting layer in the organic EL device of the present invention at least contains a phosphorescent polymer that has a phosphorescent unit emitting phosphorescence and a carrier transport unit transporting carriers, in the molecule. Such phosphorescent polymers may be obtained by copolymerizing a phosphorescent compound having a polymerizable substituent group and a carrier transporting compound having a polymerizable substituent group. The phosphorescent compounds may be metal complexes containing a metal selected from iridium, platinum and gold, and iridium complexes are particularly preferred.

Examples of the phosphorescent compounds having a polymerizable substituent group include compounds as represented by Formulae (E-1) to (E-49) below wherein one or more hydrogen atoms in the metal complexes are substituted with polymerizable substituent groups.

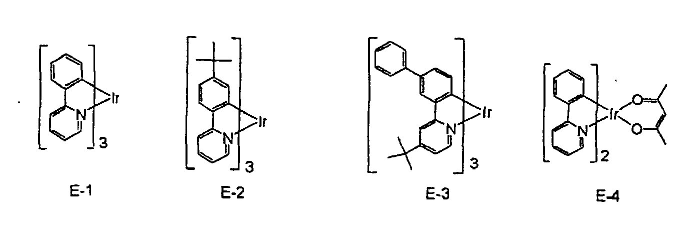

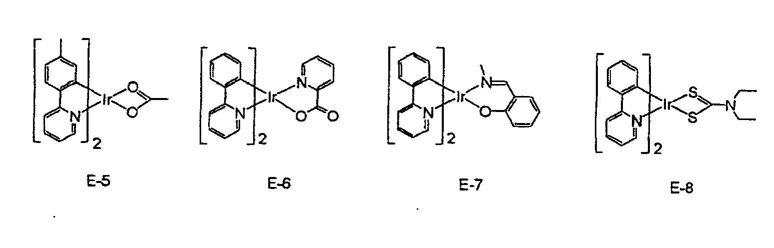

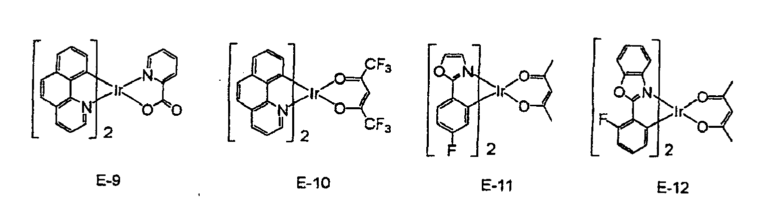

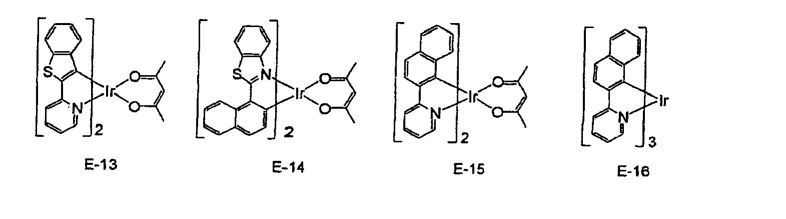

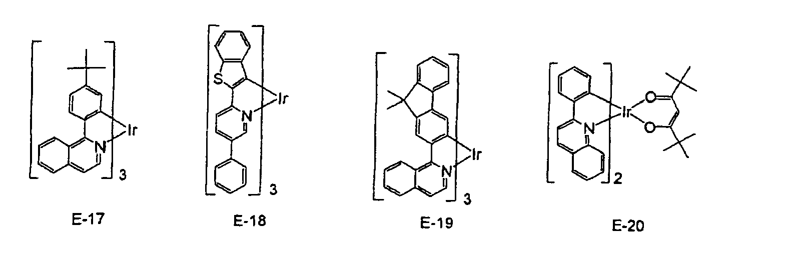

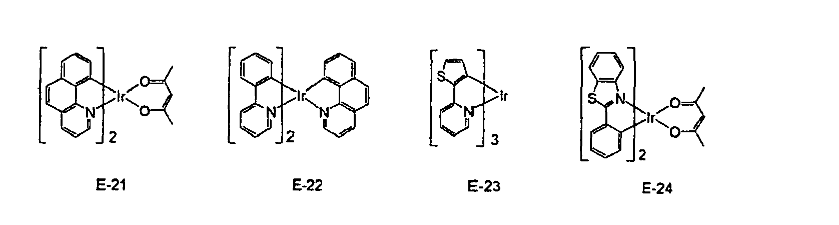

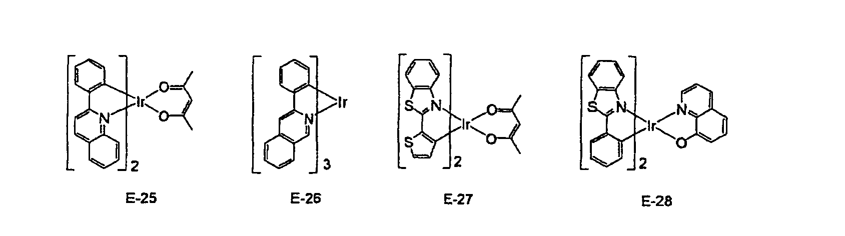

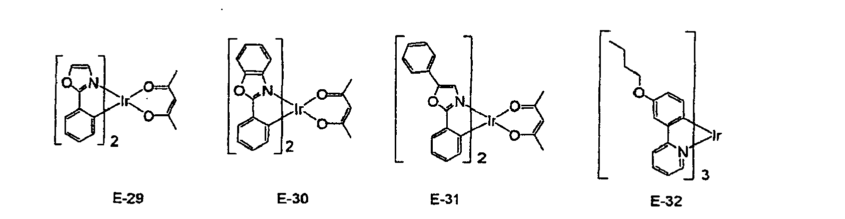

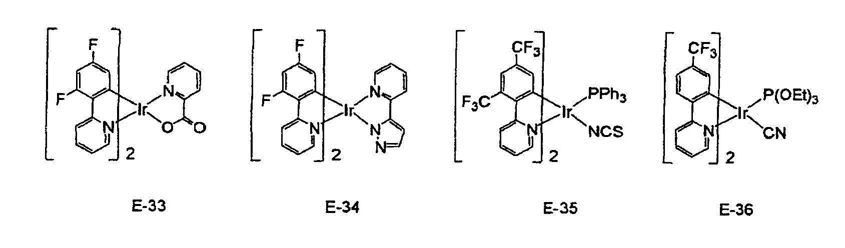

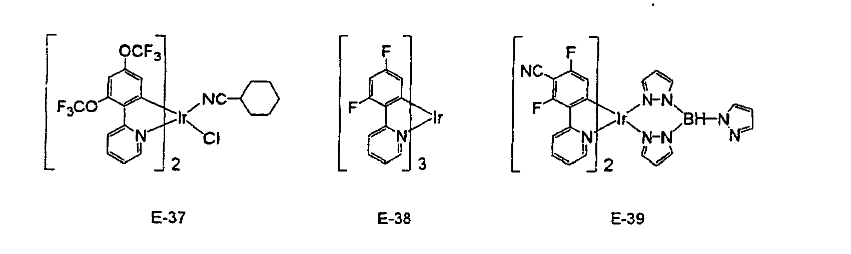

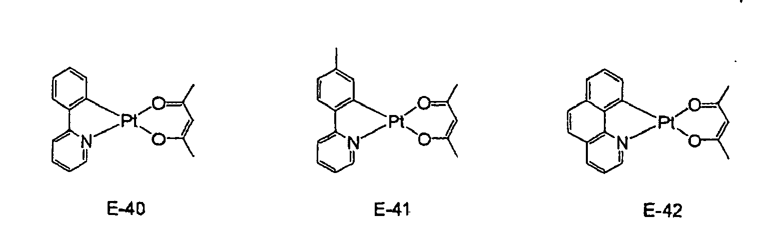

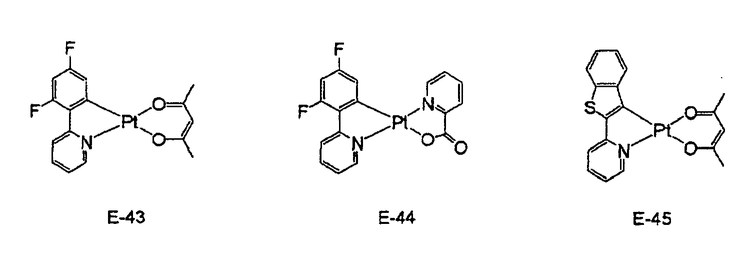

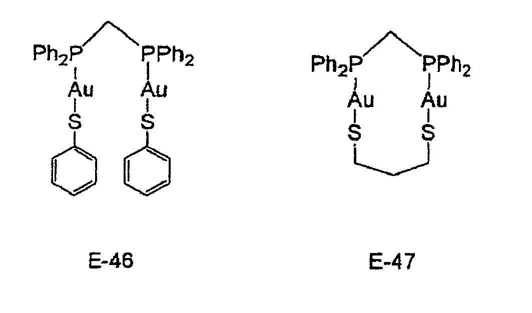

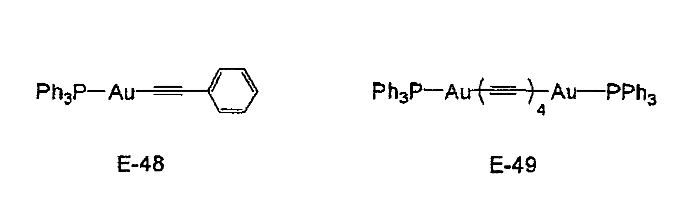

In Formulae (E-35) and (E-46) to (E-49), Ph indicates a phenyl group.
Examples of the polymerizable substituent groups in these phosphorescent compounds include vinyl group, acrylate group, methacrylate group, urethane (meth)acrylate groups such as methacryloyloxyethyl carbamate group; styryl group and derivatives thereof, and vinylamide group and derivatives thereof. Of these, vinyl group, methacrylate group, styryl group and derivatives thereof are preferred. These substituent groups may be bonded to the metal complexes via C1-20 organic groups optionally having a heteroatom.

Examples of the carrier transporting compounds having a polymerizable substituent group include organic compounds which have either or both of hole transporting properties and electron transporting properties and in which one or more hydrogen atoms of the organic compounds are substituted with polymerizable substituent groups. Specific examples of such compounds include those represented by Formulae (E-50) to (E-67) below:

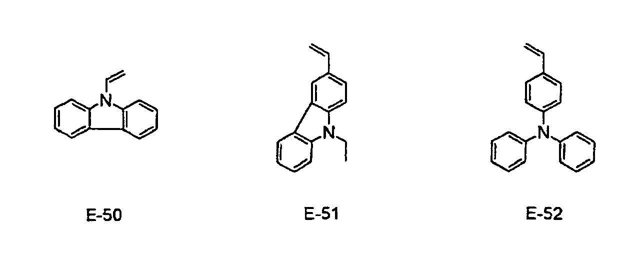

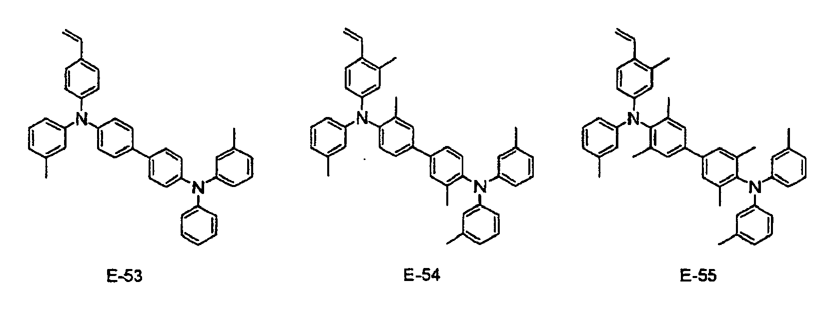

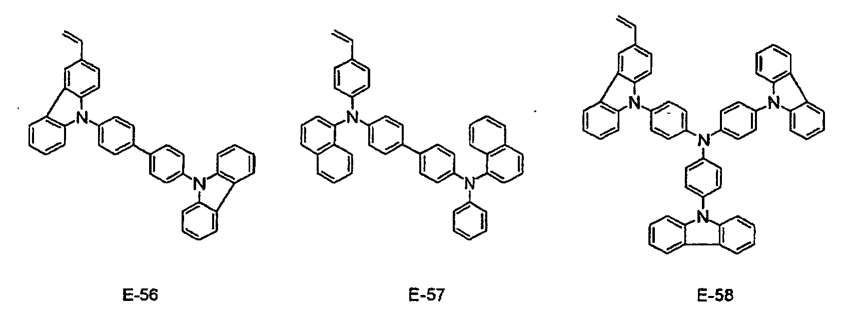

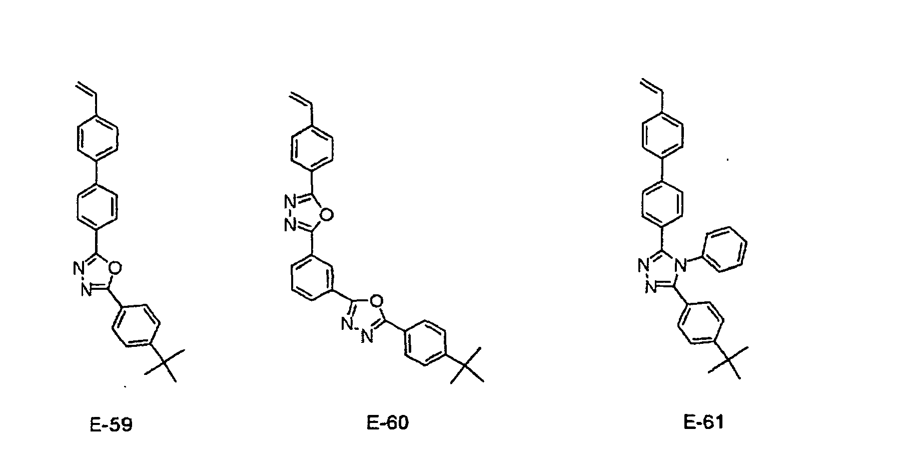

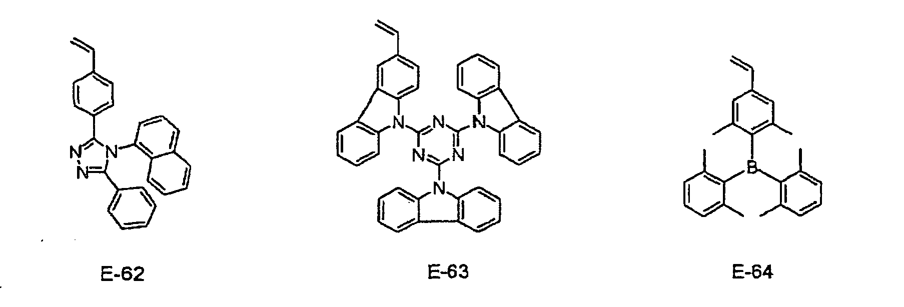

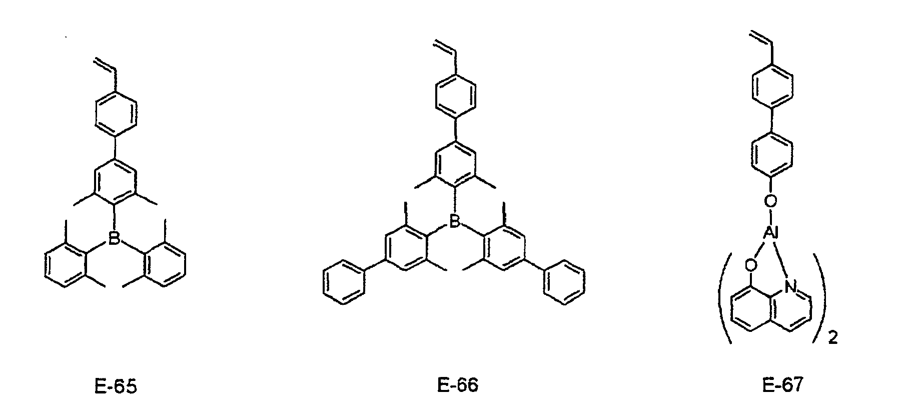

The above carrier transporting compounds are illustrated with a vinyl group as the polymerizable substituent group. Examples further include those corresponding to the above compounds except that the vinyl group is replaced by other polymerizable substituent groups such as acrylate group, methacrylate group, urethane (meth)acrylate groups such as methacryloyloxyethyl carbamate group; styryl group and derivatives thereof, and vinylamide group and derivatives thereof. These polymerizable substituent groups may be bonded to the organic compounds via C1-20 organic groups optionally having a heteroatom.

The phosphorescent compounds having a polymerizable substituent group and the carrier transporting compounds having a polymerizable substituent group may be polymerized by any polymerization methods such as radical polymerization, cationic polymerization, anionic polymerization and addition polymerization, with radical polymerization being preferable. The weight average molecular weight of the polymers is preferably in the range of 1,000 to 2,000,000, and more preferably 5, 000 to 1, 000, 000. The molecular weight herein is that measured by GPC (gel permeation chromatography) relative to polystyrene standards.

The phosphorescent polymers may be copolymers of one phosphorescent compound and one carrier transporting compound, copolymers of one phosphorescent compound and two or more carrier transporting compounds, or copolymers of two or more phosphorescent compounds and a carrier transporting compound(s).

As for the monomer arrangements, the phosphorescent polymers may be random copolymers, block copolymers or alternating copolymers. Provided that the letter m represents the number of repeating units having the phosphorescent compound structure and the letter n indicates the number of repeating units having the carrier transporting compound structure (m and n are each an integer of 1 or greater), the proportion of the number of repeating units having the phosphorescent compound structure relative to the number of all the repeating units, namely m/(m+n), is preferably in the range of 0.001 to 0.5, and more preferably 0.001 to 0.2.

The phosphorescent polymers and synthesis methods thereof are described in detail in, for example, JP-A-2003-342325, JP-A-2003-119179, JP-A-2003-113246, JP-A-2003-206320, JP-A-2003-147021, JP-A-2003-171391, JP-A-2004-346312 and JP-A-2005-97589.

The emitting layers in the organic EL devices manufactured by the processes of the present invention contain the phosphorescent compounds according to a preferred embodiment as described above. To achieve higher carrier transporting properties, the emitting layers may contain a hole transporting compound or an electron transporting compound. Examples of the hole transporting compounds used for this purpose include low molecular weight triphenylamine derivatives such as TPD (N,N'-dimethyl-N,N'-(3-methylphenyl)-1,1'-biphenyl-4,4'-diamine), α-NPD (4,4'-bis[N-(1-naphthyl)-N-phenylamino]biphenyl) and m-MTDATA (4,4',4"-tris(3-methylphenylphenylamino) triphenylamine); polyvinylcarbazole; polymers obtained by introducing polymerizable functional groups to the triphenylamine derivatives followed by polymerization, such as polymer compounds having a triphenylamine skeleton as disclosed in JP-A-H08-157575; poly(p-phenylenevinylene); and poly(dialkylfluorene). Examples of the electron transporting compounds include known electron transporting compounds, for example low molecular weight materials, including quinolinol derivative metal complexes such as Alq₃ (aluminum trisquinolinolate), oxadiazole derivatives, triazole derivatives, imidazole derivatives, triazine derivatives and triarylborane derivatives; and polymer compounds obtained by introducing polymerizable functional groups to the low molecular weight electron transporting compounds followed by polymerization, such as poly-PBD as disclosed in JP-A-H10-1665.

### (5. Methods of forming organic EL compound layers)

The organic EL compound layers may be formed by methods such as resistance heating evaporation, electron beam deposition, sputtering, application methods such as spin coating, casting, microgravure coating, gravure coating, bar coating, roll coating, wire bar coating, dip coating, spray coating, screen printing, flexographic printing, off-set printing and inkjet printing. Resistance heating evaporation and electron beam deposition may be usually used for the luminescent low molecular weight compounds. The luminescent high molecular weight compounds may be usually applied by spin coating, casting, microgravure coating, gravure coating, bar coating, roll coating, wire bar coating, dip coating, spray coating, screen printing, flexographic printing, off-set printing and inkjet printing.

### (6. Hole blocking layers)

To prevent holes from passing through the emitting layer and to ensure that the holes are recombined with electrons in the emitting layer more efficiently, a hole blocking layer may be provided adjacent to the emitting layer on the cathode side. The hole blocking layer may be produced using a compound that has a highest occupied molecular orbital (HOMO) level deeper than that of the luminescent compounds, with examples including triazole derivatives, oxadiazole derivatives, phenanthroline derivatives and aluminum complexes.

Further, an exciton blocking layer may be provided adjacent to the emitting layer on the cathode side to prevent the excitons from being deactivated by the cathode metal. The exciton blocking layer may be formed using a compound that has a triplet excited state energy higher than that of the luminescent compounds, with examples including triazole derivatives, phenanthroline derivatives and aluminum complexes.

### (7. Cathodes)

The cathode materials for the organic EL devices of the present invention may be known cathode materials that have a low work function and are chemically stable, with examples including Al, MgAg alloy and alloys of Al and alkali metals such as AlLi and AlCa. In view of chemical stability, it is preferable to use materials having a work function of not more than -2.9 eV. These cathode materials may be formed into layers by methods such as resistance heating evaporation, electron beam deposition, sputtering and ion plating. The thickness of the cathodes is preferably in the range of 10 nm to 1 µm, and more preferably 50 to 500 nm.

To lower the barrier for the electron injection from the cathode to the organic layers and thereby to increase the electron injection efficiency, a cathode buffer layer of a metal having a lower work function than the cathode may be interposed between the cathode and the organic layer adjacent to the cathode. Examples of the low work function metals include alkali metals (Na, K, Rb and Cs), alkaline earth metals (Sr, Ba, Ca and Mg) and rare earth metals (Pr, Sm, Eu and Yb). Further, alloys and metal compounds may be used as long as their work functions are lower than that of the cathode. The cathode buffer layers may be produced by methods such as deposition and sputtering. The thickness of the cathode buffer layers is preferably in the range of 0.05 to 50 nm, more preferably 0.1 to 20 nm, and still more preferably 0.5 to 10 nm.

In an embodiment, the cathode buffer layer may be formed of a mixture of the above low work function substance and an electron transporting compound. The electron transporting compounds used herein may be the organic compounds used in the electron transport layers described above. Such cathode buffer layers may be formed by a codeposition method. In the case where such layers can be formed by the application of a solution, the foregoing methods such as spin coating, dip coating, inkjet printing, printing, spraying and dispenser printing may be adopted. The thickness of such cathode buffer layers is preferably in the range of 0.1 to 100 nm, more preferably 0.5 to 50 nm, and still more preferably 1 to 20 nm. In another embodiment, a conductive polymer layer or a layer of metal oxide, metal fluoride or insulating organic material having an average thickness of not more than 2 nm may be provided between the cathode and the organic layer.

### (8. Sealing)

After the cathode is prepared, a protective layer for protecting the organic EL device may be provided. To allow for long and stable use of the organic EL devices, a protective layer and/or a protective cover is preferably provided to protect the device from the outside environment. Polymer compounds, metal oxides, metal fluorides and metal borides may be used to form the protective layers. The protective covers may be glass plates, plastic plates having a low water permeable surface, and metals. In a preferred embodiment, these covers are tightly laminated with the device substrates through a thermosetting resin or a photocurable resin. The use of spacers provides spaces in the packages and facilitates the prevention of scratches on the devices. Filling the spaces with inert gases such as nitrogen and argon prevents the oxidation of the cathodes. The placement of desiccants such as barium oxide in the spaces makes it easily possible to suppress water that has adsorbed on the devices during the manufacturing from causing damages to the devices. It is preferable that one or more of these approaches are adopted.

### (9. Substrates)

The substrates for the organic EL devices according to the present invention may be materials that have mechanical strength required for organic EL devices and are not substantially dissolved or deformed when soaked in the alkaline aqueous solution.

Substrates that are transparent to visible light may be used for bottom-emitting organic EL devices. Specific examples include glasses such as soda glass and alkali-free glass; transparent plastics such as acrylic resins, methacrylic resins, polycarbonate resins, polyester resins and nylon resins; and silicon substrates.

Examples of the substrates for top-emitting organic EL devices include the substrates for the bottom-emitting organic EL devices; and substrates made of single metals such as copper, silver, gold, platinum, tungsten, titanium, tantalum and niobium, alloys thereof, or stainless steel.

The thickness of the substrates varies depending on the mechanical strength required, but is preferably in the range of 0.1 to 10 mm, and more preferably 0.25 to 2 mm.

### EXAMPLES

The present invention will be described in greater detail based on examples hereinbelow without limiting the scope of the invention.

### [Measurement methods]

### 1. ITO electrodes (ITO layers)

### (Work function)

The work function was measured by photoelectron spectroscopy in the air (AC-2 manufactured by RIKEN KEIKI Co. , Ltd.).

### (Surface roughness)

The surface roughness Ra was determined with an atomic force microscope (atomic force microscope VN-8010 manufactured by KEYENCE CORPORATION) (field of view: 1 µm, in accordance with JIS 1994).

### (Contact angle)

Water was dropped in a diameter of 100 µm on the surface of an ITO-coated glass substrate, and the contact angle was measured by a drop method (a θ/2 method) using CA-D (manufactured by Kyowa Interface Science Co., Ltd.). In Table 1, the contact angle being less than 4° indicates that the water droplet did not form a circle and the contact angle could not be numerically evaluated.

### 2. Organic EL devices

### (Luminous efficiency)

Organic EL devices were energized stepwise with use of a constant voltage power source (SM2400 manufactured by Keithley Instruments Inc.), and the luminescence intensity of the organic EL devices was quantitatively determined with a brightness meter (BM-9 manufactured by TOPCON CORPORATION). Further, the luminous efficiency was determined from the ratio of the luminescence intensity to the current density.

### (Emission lifetime)

The organic EL devices were continuously energized at a constant current with use of the above power source, and the brightness was measured at regular time intervals to determine the emission lifetime (the time in which the initial brightness decreased by half).

### (Unevenness in brightness)

Brightness was measured in arbitrary 10 points in an arbitrary 4 x 4 cm square on the emitting surface, and the unevenness in brightness was evaluated based on the degree of difference in brightness. In detail, the standard deviation of the ten brightness values was divided with the average of the ten brightness values. The smaller the quotient (in general, referred to as the relative standard deviation), the smaller the unevenness in brightness.

### (Leakage current)

A reverse voltage of 5 V was applied to the organic EL devices, and the current per unit device area was measured. The smaller the current, the lower the leakage current.

### [Production Example 1]

A compound represented by foregoing Formula E-2 (an iridium complex having a polymerizable substituent group), a compound represented by foregoing Formula E-54 (a hole transporting compound) and a compound represented by foregoing Formula E-66 (an electron transporting compound) were dissolved in dehydrated toluene in a ratio (mass ratio) E-2:E-54:E-66 of 1:4:5. Further, polymerization initiator V-601 (manufactured by Wako Pure Chemical Industries, Ltd.) was dissolved therein. The solution was freeze degassed and was sealed in vacuum, and the reaction was carried out at 70°C for 100 hours with stirring. After the reaction, the reaction liquid was dropped into acetone to form a precipitate. The reprecipitation and purification from toluene-acetone were repeated another three times, thereby purifying the phosphorescent polymer compound. The acetone and toluene used herein were distillates of high-purity grade reagents (manufactured by Wako Pure Chemical Industries, Ltd.).

The solvent after reprecipitation/purification was analyzed by high performance liquid chromatography. It was confirmed that the solvent after the third reprecipitation/purification did not contain any substances showing absorption peaks above 400 nm.
The purified phosphorescent polymer compound was dried in vacuum at room temperature for 2 days.

High performance liquid chromatography (detection wavelength: 254 nm) provided that the phosphorescent polymer compound (ELP) obtained had a purity of more than 99.9%.

### [Example 1]

Pure water (electrical conductivity: 1 µS/cm, the same applies hereinafter) was added to liquid glass (SiO₂-Na₂O, manufactured by Wako Pure Chemical Industries, Ltd., SiO₂ concentration: 52-57%) to prepare an aqueous solution which contained sodium silicate at about 0.32% by mass in terms of Si atoms and 0.23% by mass in terms of Na atoms (Na⁺ ions/Si atoms = 0.9 (molar ratio)). The pH of the aqueous solution at room temperature was about 13. The aqueous solution was warmed to 40°C. With the temperature maintained at 40°C, an ITO-coated glass substrate (manufactured by GEOMATEC Corporation, flat ITO, shape: 200 x 200 mm square, work function of the ITO electrode: -4.8 eV, contact angle with water: 25°) was soaked in the aqueous solution for 24 hours with stirring with a magnetic stirrer.

The ITO-coated glass substrate was taken out of the solution and was immediately placed in a beaker filled with pure water. The ITO-coated glass substrate was washed by being swayed a little in the water for 5 minutes. The substrate was taken out from the water and was immediately set in a spin dryer. The surface of the ITO-coated glass substrate was dried by rotation at 3000 rpm.

The ITO-coated glass substrate was allowed to stand at room temperature for 1 hour and the surface thereof was further dried. The work function of the ITO layer surface and the surface roughness of the ITO layer were measured. The results are set forth in Table 1. After the measurements, the ITO layer on the substrate was spin coated (3000 rpm) with a luminescent solution (a 3% by mass toluene solution of the phosphorescent polymer compound (ELP) from Production Example 1) in an atmospheric atmosphere and was allowed to stand in a nitrogen atmosphere at 120°C for 1 hour, thereby forming an emitting layer on the substrate. The contact angle with water of the ITO layer is shown in Table 1.

The substrate having the emitting layer was placed in a vacuum deposition chamber. On the emitting layer on the substrate, a LiF layer was formed as a cathode buffer layer in a thickness of 0.5 nm with a vacuum deposition apparatus. Subsequently, an Al layer was formed as a cathode in a thickness of 150 nm. An organic EL device was thus manufactured.

The luminous efficiency, unevenness in brightness, leakage current and emission lifetime of the organic EL device are set forth in Table 1.

### [Example 2]

Pure water was added to liquid glass (SiO₂-Li₂O, manufactured by NISSAN CHEMICAL INDUSTRIES, LTD., SiO₂ concentration: 20%) to prepare an aqueous solution which contained lithium silicate at 0.45% by mass in terms of Si atoms and 0.03% by mass in terms of Li atoms (Li⁺ ions/Si atoms = 0.27 (molar ratio)). The pH of the aqueous solution at room temperature was 13.

The aqueous solution was placed in a container (a tank) that had been warmed to 60 °C, and the temperature of the aqueous solution was maintained at 60°C. A substrate was conveyed on rollers (conveyance speed: 2 mm/sec) and was brought into contact with the alkaline solution and washed with pure water in the following manner.

The aqueous solution in the tank was fed to an ultrasonic nozzle (BR-073B manufactured by Branson Ultrasonics Corporation) through a pipe, and the aqueous solution was injected therefrom over the substrate for 10 minutes. The aqueous solution that was brought from the ultrasonic nozzle into contact with the substrate was ultrasonicated.

Immediately after the contact step, pure water was injected to the substrate through a line shower (equipment that had a plurality of water outlets arranged substantially perpendicular to the direction of conveying the substrate). While pure water was injected through the line shower, the substrate was washed with a rotating roller brush for 3 minutes. Subsequently, the substrate was passed under an air knife to remove water from the substrate surface.

The ITO-coated glass substrate was allowed to stand at room temperature for 1 hour and the surface thereof was further dried. The work function of the ITO layer surface and the surface roughness of the ITO layer were measured in the same manner as in Example 1. The results are set forth in Table 1.

After the measurements, the ITO layer on the substrate was spin coated (3000 rpm) with a luminescent solution (a 1% by mass anisole solution of the phosphorescent polymer compound (ELP) from Production Example 1) in an atmospheric atmosphere and was allowed to stand in a nitrogen atmosphere at 120°C for 1 hour, thereby forming an emitting layer on the substrate. The contact angle with water of the ITO layer is shown in Table 1.

The substrate having the emitting layer was placed in a vacuum deposition chamber. On the emitting layer on the substrate, a Na layer was formed as a cathode buffer layer in a thickness of 2.0 nm with a vacuum deposition apparatus. Subsequently, an Al layer was formed as a cathode in a thickness of 150 nm. An organic EL device was thus manufactured.

The luminous efficiency, unevenness in brightness, leakage current and emission lifetime of the organic EL device are set forth in Table 1.

### [Example 3]

An organic EL device was manufactured in the same manner as in Example 1, except that after the surface of the ITO-coated glass substrate was dried with the spin dryer, the ITO-coated glass substrate was allowed to stand in a clean oven (PVC-331 manufactured by ESPEC CORP.) at 120°C for 30 minutes and was thereafter naturally cooled to room temperature, followed by measurements of the work function of the ITO layer surface and the surface roughness of the ITO layer.

The measurement results of the ITO layer and the organic EL device are set forth in Table 1.

### [Example 4]

An organic EL device was manufactured in the same manner as in Example 1, except that after the surface of the ITO-coated glass substrate was dried with the spin dryer, the ITO-coated glass substrate was irradiated with UV rays for 5 minutes with use of a UV irradiating apparatus (UV-300H manufactured by SAMCO, Inc.), followed by measurements of the work function of the ITO layer surface and the surface roughness of the ITO layer.

The measurement results of the ITO layer and the organic EL device are set forth in Table 1.

### [Example 5]

An organic EL device was manufactured in the same manner as in Example 4, except that the UV irradiation was performed in the UV irradiating apparatus filled with dry air, and the ITO-coated substrate was thereafter quickly transferred in a glove box filled with nitrogen and the emitting layer was fabricated in the nitrogen atmosphere.

The measurement results of the ITO layer and the organic EL device are set forth in Table 1.

### [Example 6]

Pure water was added to liquid glass (SiO₂-Na₂O, manufactured by Wako Pure Chemical Industries, Ltd., SiO₂ concentration: 52-57%) to prepare an aqueous solution which contained sodium silicate at about 0.32% by mass in terms of Si atoms and 0.23% by mass in terms of Na atoms (Na⁺ ions/Si atoms = 0. 9 (molar ratio)). The pH of the aqueous solution at room temperature was about 13. At room temperature (25°C), the aqueous solution was dropped on an ITO-coated glass substrate (manufactured by GEOMATEC Corporation, flat ITO, shape: 200 x 200 mm square, work function of the ITO electrode: -4.8 eV, contact angle with water: 25°) that was set in a spin coater. The ITO-coated glass substrate was immediately rotated at 3000 rpm and thereby the aqueous solution was spread over the entire surface of the substrate. The rotation was continued for another 60 seconds.

The ITO-coated glass substrate was allowed to stand at room temperature for 1 hour and the surface thereof was further dried. The work function of the ITO layer surface and the surface roughness of the ITO layer were measured. The results are set forth in Table 1.
An organic EL device was manufactured using the ITO-coated glass substrate in the same manner as in Example 1.

The measurement results of the ITO layer and the organic EL device are set forth in Table 1.

### [Example 7]

The aqueous solution described in Example 6 was spread over the substrate surface in the similar manner.

The ITO-coated glass substrate was continuously rotated at 3000 rpm for another 60 seconds.
The ITO-coated glass substrate was then washed by pouring pure water over them with rotation at 500 rpm for 3 minutes.

The pouring pure water was terminated, and the ITO-coated glass substrate was dried by being rotated at 3000 rpm for 30 seconds and standing at room temperature for 1 hour. The work function of the ITO layer surface and the surface roughness of the ITO layer were measured. The results are set forth in Table 1.

An organic EL device was manufactured using the ITO-coated glass substrate in the same manner as in Example 1.
The measurement results of the ITO layer and the organic EL device are set forth in Table 1.

### [Example 8]

A pure water/isopropyl alcohol (IPA) mixture solution (water/IPA = 4/1 (volume ratio)) was added to liquid glass (SiO₂-Na₂O, manufactured by Wako Pure Chemical Industries, Ltd. , SiO₂ concentration: 52-57%) to prepare an aqueous solution which contained sodium silicate at about 0.08% by mass in terms of Si atoms and 0.06% by mass in terms of Na atoms (Na⁺ ions/Si atoms = 0.9 (molar ratio)). The pH of the solution at room temperature was about 11. An ITO-coated glass substrate was treated and an organic EL device was manufactured in the same manner as in Example 6, except that the above aqueous solution was used.

The measurement results of the ITO layer and the organic EL device are set forth in Table 1.

### [Example 9]

Pure water was added to liquid glass (SiO₂-Na₂O, manufactured by Wako Pure Chemical Industries, Ltd., SiO₂ concentration: 52-57%) to prepare an aqueous solution which contained sodium silicate at about 0.16% by mass in terms of Si atoms and 0.12% by mass in terms of Na atoms (Na⁺ ions/Si atoms = 0.9 (molar ratio)). The pH of the aqueous solution at room temperature was about 12. The temperature of the aqueous solution was maintained at 40°C, and an ITO-coated glass substrate (manufactured by GEOMATEC Corporation, flat ITO, shape: 200 x 200 mm square, work function of the ITO electrode: -4.8 eV, contact angle with water: 25°) that was set in a dip coater was soaked in the aqueous solution. The substrate was then lifted from the solution at a speed of 1 mm/sec. It took 3 minutes from the initiation of the soaking of the substrate to the completion of the lifting.

The ITO-coated glass substrate lifted from the aqueous solution was allowed to stand at room temperature for 1 hour and thereby the surface thereof was dried. The work function of the ITO layer surface and the surface roughness of the ITO layer were measured. The results are set forth in Table 1.

An organic EL device was manufactured using the ITO-coated glass substrate in the same manner as in Example 1.
The measurement results of the ITO layer and the organic EL device are set forth in Table 1.

### [Example 10]

Pure water was added to liquid glass (SiO₂-Na₂O, manufactured by Wako Pure Chemical Industries, Ltd., SiO₂ concentration: 52-57%) to prepare an aqueous solution which contained sodium silicate at about 0.64% by mass in terms of Si atoms and 0.48% by mass in terms of Na atoms (Na⁺ ions/Si atoms = 0.9 (molar ratio)). The pH of the aqueous solution at room temperature was about 13. The aqueous solution was spread over an ITO-coated glass substrate (manufactured by GEOMATEC Corporation, flat ITO, shape: 200 x 200 mm square, work function of the ITO electrode: -4.8 eV, contact angle with water: 25°) by means of a bar coater (No. 3 manufactured by Daiichi Rika K.K.) in 2 seconds at a speed of 100 mm/sec, thereby forming a layer.

The ITO-coated glass substrate was allowed to stand at room temperature for 1 hour and thereby the surface thereof was dried. The work function of the ITO layer surface and the surface roughness of the ITO layer were measured. The results are set forth in Table 1.
An organic EL device was manufactured using the ITO-coated glass substrate in the same manner as in Example 1.

The measurement results of the ITO layer and the organic EL device are set forth in Table 1.

### [Example 11]

Pure water and a 1% by weight aqueous sodium hydroxide solution were added to liquid glass (SiO₂-Na₂O, manufactured by KANTO CHEMICAL CO., INC., SiO₂ concentration: 35-38%) to prepare an aqueous solution which contained sodium silicate at about 0.16% by mass in terms of Si atoms and 0.24% by mass in terms of Na atoms (Na⁺ ions/Si atoms = 1.8 (molar ratio)). The pH of the aqueous solution at room temperature was about 12. An ITO-coated glass substrate was treated and an organic EL device was manufactured in the same manner as in Example 6, except that the above aqueous solution was used.

The measurement results of the ITO layer and the organic EL device are set forth in Table 1.

### [Example 12]

Pure water was added to liquid glass (SiO₂-Na₂O, manufactured by KANTO CHEMICAL CO., INC., SiO₂ concentration: 35-38%) to prepare an aqueous solution which contained sodium silicate at about 0.32% by mass in terms of Si atoms and 0.24% by mass in terms of Na atoms (Na⁺ ions/Si atoms = 0.9 (molar ratio)). Polyvinylpyrrolidone (molecular weight: 100,000) as a nonionic surfactant was added to the solution in such an amount that concentration thereof becomes 0.01% by weight. The pH of the aqueous solution at room temperature was about 12. The aqueous solution was screen printed over an ITO substrate (similar to that used in Example 1) through a screen mesh No. 350 in 2 seconds at a speed of 100 mm/sec. The ITO substrate was then allowed to stand at room temperature for 5 minutes. Subsequently, the ITO substrate was placed in a beaker filled with pure water and was washed in the same manner as in Example 1. The succeeding procedures were carried out in the same manner as in Example 1, thereby manufacturing an organic EL device.

The measurement results of the ITO layer and the organic EL device are set forth in Table 1.

### [Comparative Example 1]

An ITO-coated glass substrate was placed in a beaker filled with pure water, and ultrasonic waves were applied thereto. The substrate was taken out, immediately set in a spin dryer, and rotated at 3000 rpm, thereby drying the surface of the ITO-coated glass substrate.

The ITO-coated glass substrate was allowed to stand at room temperature for 1 hour and the surface thereof was further dried. The work function of the ITO layer surface and the surface roughness of the ITO layer were measured in the same manner as in Example 1. The results are set forth in Table 1.
After the measurements, an emitting layer, a cathode buffer layer and a cathode were fabricated on the ITO layer side of the substrate in the same manner as in Example 1, thereby manufacturing an organic EL device.

The contact angle of the ITO layer, and the luminescence intensity, luminous efficiency and emission lifetime of the organic EL device were measured in the same manner as in Example 1. The results are set forth in Table 1.

| Device | Work function (eV) | Surface roughness (nm) | Contact angle (°) | Luminous efficiency (cd/A) | Unevenness in brightness (%) | Leakage current (mA/cm²) | Emission lifetime (hours) |
|---|---|---|---|---|---|---|---|
| Ex. 1 | -5.7 | 0.6 | Less than 4 | 18 | 16 | 0.016 | 250 |
| Ex. 2 | -5.6 | 0.4 | Less than 4 | 20 | 10 | 0.010 | 250 |
| Ex. 3 | -5.6 | 0.4 | Less than 4 | 21 | 9 | 0.010 | 300 |
| Ex. 4 | -5.8 | 0.4 | Less than 4 | 23 | 9 | 0.009 | 400 |
| Ex. 5 | -5.9 | 0.4 | Less than 4 | 24 | 8 | 0.008 | 450 |
| Ex. 6 | -5.7 | 0.4 | Less than 4 | 25 | 7 | 0.008 | 250 |
| Ex. 7 | -5.8 | 0.4 | Less than 4 | 21 | 6 | 0.008 | 300 |
| Ex. 8 | -5.8 | 0.3 | Less than 4 | 24 | 5 | 0.007 | 350 |
| Ex. 9 | -5.7 | 0.4 | Less than 4 | 21 | 7 | 0.008 | 300 |
| Ex. 10 | -5.7 | 0.4 | Less than 4 | 20 | 7 | 0.009 | 300 |
| Ex. 11 | -5.7 | 0.4 | Less than 4 | 22 | 6 | 0.008 | 300 |
| Ex. 12 | -5.8 | 0.4 | Less than 4 | 22 | 8 | 0.010 | 400 |
| Comp. Ex. 1 | -4.8 | 1.0 | 25 | 2 | 25 | 0.12 | 0.2 |

The results in Table 1 show that the surface treatment for the ITO layers (anodes) increased the work function of the ITO layers (anodes) and reduced the surface roughness thereof, and also increased the luminous efficiency and the emission lifetime of the organic EL devices.

## Claims

1. A process for treating an electrode surface, comprising a contact step of bringing an electrode comprising a metal oxide or a metal into contact with an alkaline solution of a compound having an Si-O bond.

2. The process for treating an electrode surface according to claim 1, wherein the compound having an Si-O bond is a silicate.

3. The process for treating an electrode surface according to claim 2, wherein the silicate is at least one selected from the group consisting of sodium silicate, potassium silicate, rubidium silicate and lithium silicate.

4. The process for treating an electrode surface according to any one of claims 1 to 3, wherein the alkaline solution contains the compound having an Si-O bond in a concentration of 0.001 to 15% by mass in terms of Si atoms.

5. The process for treating an electrode surface according to any one of claims 1 to 4, wherein the alkaline solution contains an alkali metal ion and the molar concentration of the alkali metal ion in the alkaline solution is 0.1 to 10 times the molar concentration in terms of Si atoms of the compound having an Si-O bond.

6. The process for treating an electrode surface according to any one of claims 1 to 5, wherein the contact step is performed by soaking the electrode in the alkaline solution.

7. The process for treating an electrode surface according to any one of claims 1 to 5, wherein the contact step is performed by spraying the alkaline solution to the electrode.

8. The process for treating an electrode surface according to any one of claims 1 to 5, wherein the contact step is performed by applying the alkaline solution to the surface of the electrode.

9. The process for treating an electrode surface according to claim 8, wherein the application is performed by forming a puddle of the alkaline solution on the surface of the electrode and rotating the electrode in an in-plane direction of the electrode surface to spread the puddle of the solution over the entire surface of the electrode.

10. The process for treating an electrode surface according to claim 9, wherein the application is performed by a spin coating method or a casting method.

11. The process for treating an electrode surface according to claim 8, wherein the application is performed by a microgravure coating method, a gravure coating method, a bar coating method, a roll coating method, a wire bar coating method, a dip coating method, a spray coating method, a screen printing method, a flexographic printing method, an off-set printing method or an inkjet printing method.

12. The process for treating an electrode surface according to any one of claims 1 to 11, wherein the process further comprises a washing step of washing the electrode with water after the contact step.

13. The process for treating an electrode surface according to claim 12, wherein the washing step is performed by at least one method selected from the group consisting of a brush washing method, a two-fluid washing method, an ultrasonic washing method, a high-pressure jet washing method and a spin washing method.

14. The process for treating an electrode surface according to any one of claims 1 to 13, wherein the process further comprises a heating step of heating the electrode to 60 to 250°C, the heating step being performed at a stage after the contact step (when the process comprises the washing step, the heating step being performed at a stage after the washing step).

15. The process for treating an electrode surface according to any one of claims 1 to 14, wherein the process further comprises a UV irradiation step of irradiating the electrode with UV rays, the UV irradiation step being performed at a stage after the contact step (when the process comprises the washing step, the UV irradiation step being performed at a stage after the washing step).

16. An electrode comprising a metal oxide or a metal, which has been surface-treated by the process described in any one of claims 1 to 15.

17. An electrode comprising indium tin oxide, which has been surface-treated by the process described in any one of claims 1 to 15 and has a work function of -5.2 to -6.0 eV as measured by ultraviolet photoelectron spectroscopy in the air.

18. A process for manufacturing organic electroluminescence devices which comprise an anode, an emitting layer and a cathode laminated in this order, wherein the process comprising forming the emitting layer and the cathode on the anode that comprises a metal oxide or a metal and has been surface-treated by the process described in any one of claims 1 to 15.

19. An organic electroluminescence device comprising an anode, an emitting layer and a cathode laminated in this order, wherein the anode comprises a metal oxide or a metal and has been surface-treated by the process described in any one of claims 1 to 15.
